Europäisches Patentamt

European Patent Office

Office européen des brevets

(11) Publication number: **0 177 902 B1**

# EUROPEAN PATENT SPECIFICATION

(45) Date of publication of patent specification: **09.10.91**    (51) Int. Cl.5: **H03M 1/80**

(21) Application number: **85112533.6**

(22) Date of filing: **03.10.85**

(54) Digital-to-analog converter.

(30) Priority: **04.10.84 JP 208749/84**

(43) Date of publication of application:
**16.04.86 Bulletin  86/16**

(45) Publication of the grant of the patent:
**09.10.91 Bulletin  91/41**

(84) Designated Contracting States:
**DE GB NL**

(56) References cited:
**US-A- 4 278 964**

**ELEKTRONIK, vol. 31, no. 3, February 1982,
pages 78-80, Munich, DE; G. HEINLE:
"Gleitkomma-D/A-Umsetzer verringert Quan-
tisierungsfehler"**

**IBM TECHNICAL DISCLOSURE BULLETIN,
Vol. 5, no. 5, October 1962, pages 30-31, New
York, US; T.J. HARRISON: "Logarithmic digi-
tal to analog converter"**

**U. Tietze/Ch. Schenk:
"Halbleiter-Schaltungstechnik" 5th edition,
Springer-Verlag Berlin, Heidelberg, New York
1980, p. 633-638**

(73) Proprietor: **YAMAHA CORPORATION
10-1, Nakazawa-cho
Hamamatsu-shi Shizuoka-ken(JP)**

(72) Inventor: **Kohdaka, Takayuki
c/o Yamaha Corporation 10-1, Nakazawa-cho
Hamamatsu-shi Shizuoka-ken(JP)**
Inventor: **Ishida, Katsuhiko
c/o Yamaha Corporation 10-1, Nakazawa-cho
Hamamatsu-shi Shizuoka-ken(JP)**
Inventor: **Takahashi, Toshiyuki
c/o Yamaha Corporation 10-1, Nakazawa-cho
Hamamatsu-shi Shizuoka-ken(JP)**
Inventor: **Ogata, Takashi
c/o Yamaha Corporation 10-1, Nakazawa-cho
Hamamatsu-shi Shizuoka-ken(JP)**

(74) Representative: **Kehl, Günther, Dipl.-Phys. et
al
Patentanwälte HAGEMANN & KEHL Ismanin-
ger Strasse 108
W-8000 München 80(DE)**

## Description

This invention relates to a digital-to-analog converter for converting digital data into an analog output signal ($V_{out}$) comprising mantissa digital-to-analog converting means for converting a mantissa part of said digital data into a first analog signal; circuit means responsive to said first analog signal to produce second analog signals whose voltages are $2^{-n}$ (n = 0, 1, 2, 3,...) magnifications of said first analog signal; and switch circuit means connected to said circuit means for selectively outputting one of said second analog signals as said analog output signal in accordance with an exponent part of said digital data, suitable for use in, for example, a digital audio device.

In a signal reproduction circuit of a digital audio device such as a compact disc player, a digital signal reproduced from a recording medium is converted into an analog signal. In such a case, since the digital reproduction signal generally takes the form of a binary fixed-point number, a digital-to-analog converter (hereinafter referred to as "D/A converter") of the type in which all bits of the digital reproduction signal are directly supplied to a weighted register network or an R-2R resistor ladder network is generally used.

As is well known, one of the most important features of a digital audio device is the reproducibility of a small signal with less distortion. It is also well known that distortion contained in the output signal of a D/A converter of this type increases with the decrease of magnitude of the input data. And therefore, for example, when it is desired to reproduce a signal at a level of -60 dB (full-scale level is 0 dB) with a distortion less than 1%, the D/A converter must have such a high accuracy that a signal at a level of 0 dB can be reproduced with a distortion less than 0.001%, which accuracy is equivalent to fifteen to sixteen bits. However, it is extremely difficult to improve the accuracy of a D/A converter of this type to such an extent.

US-A-4 278 964 teaches a seismic playback system and especially an apparatus for converting wide dynamic amplitude range digital data recorded in floating point digital word form, comprising a binary coded mantissa and a binary coded exponent, to an analog signal, or oscillogram, of selectively compressed and/or amplified dynamic amplitude range. The digital word, occupying a number of binary bit positions, is, in algebraic form $\pm$ $\overline{AG^E}$, where A represents the mantissa, or argument, G represents the base, or radix, of the number system used and E represents the exponent. Since the base G is constant, for example at 8, the only binary bits that need to be recorded are those representing the mantissa A and the exponent E. In reconverting the digital data to analog form for making an oscillogram, it is desired to selectively amplify and/or compress the dynamic range and, yet, at the same time avoid introducing serious distortions. The function generator for reconverting the digital data to analog form is provided with a mantissa digital to analog converting means for converting a mantissa part of said digital data into a first analog signal and circuit means responsive to said first analog signal to produce second analog signals, whose voltages are $G^E$ magnifications of said first analog signal, where G represents the base of the number system used and E represents the exponent. According to this prior art, the exponent part and the mantissa part are connected together via a buffer amplifier. In addition, by use of the positive and negative voltages to be changed over, this prior art system obtains the analog output. Since the mantissa part and the exponent part are connected via the buffer amplifier, this function generator does not lend itself to the use in digital audio devices, in which high speed operation is required.

In"Elektronik", Vol. 31, No. 3, February 1982, pages 78-80, floating-point D/A converters of high quantization accuracy are described in a general manner. This reference discloses further that the exponent is set at "2" and the D/A converter provides a r-2r-ladder network.

U. Tietze/Ch. Schenk "Halbleiter-Schaltungstechnik", 5th edition, Springer-Verlag Berlin Heidelberg New York 1980, pages 633-638 discloses a r-2r-ladder network in a general theoretical treatment.

It is therefore an object of the present invention to provide a D/A converter, which can convert a digital signal under high speed operation into an analog signal with less distortion, even, when the magnitude of the digital input signal is small.

The digital-to-analog converter according to the invention is characterized in that said circuit means comprises an r-2r ladder network directly connected at one terminal end thereof to said one terminal end of said mantissa digital-to-analog converting means for producing said second analog signals, wherein said r-2r resistor ladder network is supplied at one terminal of each 2r resistor thereof with a bias voltage to determine the center of range of said analog output signal.

According to the invention the bias voltage corresponding to the center value of the amplitude of the output analog signal is applied at the connection point between the exponent part and mantissa part, which are connected in series. Thus it is possible to omit the buffer amplifier, which is inserted between the exponent part and mantissa part of the conventional D/A converter. As a result it is possible to obtain a high speed response, when converting the digital into the analog signal with less distortions even when the magnitude of the digital input signal is small.

According to a preferred embodiment of the invention the digital-to-analog converter is provided with data converting means for converting a fixed point binary data into a floating point data composed of said mantissa and exponent part. So the D/A converter according to this preferred embodiment lends itself also to the conversion of a digital input data in the form of a fixed-point-number.

Further advantageous embodiments of the invention will now be described with reference to the accompanying drawings, in which:

Figur 1: is a circuit diagram of a D/A converter 100 provided in accordance with the present invention,

Fig. 2 is a circuit diagram of an equivalent circuit of each of the inverters 11 and 12 of the D/A converter 100 of Fig. 1;

Fig. 3 is a circuit diagram of a modified D/A converter 200 provided in accordance with the present invention;

Fig. 4 is a circuit diagram of the shift number detection circuit 107 of the D/A converter 200 of Fig. 3; and

Fig. 5 is a circuit diagram of the data shift circuit 106 of the D/A converter 200 of Fig. 3.

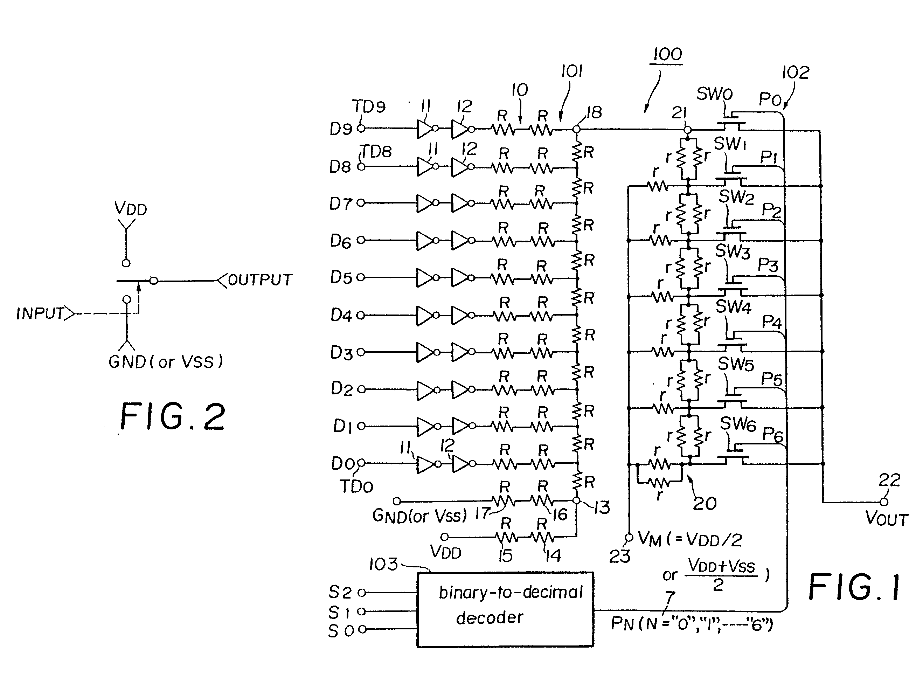

Referring now to Fig. 1, there is shown a D/A converter 100 provided in accordance with the present invention. This D/A converter 100 is of a floating-point type which can implement a digital-to-analog conversion of a small signal with less distortion as will become apparent from the following description. Shown at $TD_9$ to $TD_0$ in Fig. 1 are input terminals for being supplied respectively with bits $D_9$ to $D_0$ of a ten-bit mantissa part (or fractional part) of a floating-point digital input data to be converted into an analog signal, the bit $D_9$ being the MSB (most significant bit) of the mantissa part. Each bit of the input data is supplied to a ten-stage R-2R resistor ladder network 10 through serially connected two inverters 11 and 12. Each stage of the ladder network 10 comprises a 2R resistor composed of serially connected two resistors each having a resistance value of R, which are disposed transversely of the ladder, and an R resistor composed of a resistor having a resistance value of R which is disposed longitudinally of the ladder. In this case, the bits $D_9$ to $D_0$ of the input data are fed respectively to the 2R resistors of the first (MSB) to tenth stages of the ladder network 10. Each of the inverters 11 and 12 is equivalent to an analog switch circuit shown in Fig. 2 which is so arranged that a voltage of $V_{DD}$ is outputted when a "1" signal is inputted and that a ground level signal is outputted when a "0" signal is inputted. The inverters 11 and 12 may alternatively output a voltage of $V_{SS}$, which is lower than the voltage $V_{DD}$,

when a "0" signal is applied thereto. One terminal end 13 of the R-2R resistor ladder network 10 on the LSB (least significant bit) side is connected to a source of the reference voltage of $V_{DD}$ through serially connected two resistors 14 and 15 each having a resistance value of R. The terminal end 13 is also connected to the ground through serially connected resistors 16 and 17 each having a resistance value of R. The resistor 17 may alternatively be connected to a source of the voltage $V_{SS}$. And in this case, the inverters 11 and 12, the R-2R resistor ladder network 10 and the resistors 14 to 17 constitute a D/A conversion section 101 for the mantissa part.

Shown at 102 is a D/A conversion section for converting a three-bit exponent part of the digital input data. This D/A conversion section 102 analogically shifts the output voltage appearing at the other terminal end 18 of the ladder network 10 on the MSB side by an amount of voltage determined by the magnitude of the exponent part. The D/A conversion section 102 comprises a six-stage r-r/2 resistor ladder network 20 and seven analog switches $SW_0$ to $SW_6$ each comprising a field effect transistor (hereinafter referred to as "FET"). Each stage of the ladder network 20 except for the LSB stage comprises a 1/2r resister composed of parallel-connected two resisters each having a resistance value of r and disposed longitudinally of the ladder and an $\overline{r}$ resistor composed of a resistor having a resistance value of r and disposed transversely of the ladder. The $L\overline{S}B$ stage of the ladder network 20 is composed of two 1/2r resistors. The analog switch $SW_0$ is connected between one terminal end 21 of the ladder network 20 on the MSB side ( or a $2^0$ output terminal of the ladder network 20) and an output terminal 22 of this D/A converter 100, and the analog switch $SW_1$ is connected between the junction point of the 1/2r and r resistors of the MSB stage of the ladder network 20 (or a $2^{-1}$ output terminal of the ladder network 20) and the output terminal 22. In a similar manner, the analog switches $SW_2$ to $SW_6$ are connected respectively between $2^{-2}$ to $2^{-6}$ output terminals of the ladder network 20 and the output terminal 22. The analog switches $SW_0$ to $SW_6$ are so arranged that one of them is selectively conducted in accordance with an output of a binary-to-decimal decoder 103. The one terminal end 21 of the r-r/2 resistor ladder network 20 is connected to the terminal end 18 of the ladder network 10. The r resistors of the first (MSB) to fifth stages of the ladder network 20 and the transversely disposed 1/2r resistor of the LSB stage of the ladder network 20 are connected to a bias terminal 23 to which a bias voltage of $V_M$ equal in potential to half of the voltage $V_{DD}$ is supplied. This bias voltage $V_M$ defines the center of range of an output voltage $V_{OUT}$

of this D/A converter 100 which is derived from the output terminal 22. The voltage $V_M$ applied to the bias terminal 23 may alternatively be $(V_{DD} + V_{SS})/2$. The decoder 103 decodes bits $S_2$(MSB) to $S_0$(LSB) of the exponent part of the input data and outputs as the result of the decoding a signal $P_N$ ("N" is one of "0" to "6") to the D/A conversion section 102 to cause the Nth analog switch $SW_N$ to conduct. In this case, the "N" is expressed as follows:

$$N = \overline{S_2} \cdot 2^2 + \overline{S_1} \cdot 2^1 + \overline{S_0} \qquad (1)$$

Also, the output voltage $V_{OUT}$ of the above-described D/A converter 100 is expressed by the following formula (2):

$$V_{OUT} = 1/2\, V_{DD} + 1/4\, V_{DD} (-1 + D_9 + D_8 \cdot 2^{-1} + \dots D_0 \cdot 2^{-9} + 2^{-10}) \cdot 2^{-N} \qquad (2)$$

As is appreciated from the formula (2), with the structure of the above-described floating-point type D/A converter 100, a dynamic range of ten bits can be obtained by the mantissa part and a dynamic range of six bits can be obtained by the exponent part. And therefore, this D/A converter 100 as a whole has a resolution of sixteen bits. Moreover, when the "N" is "6", that is, when the exponent part is minimum, an error contained in the output voltage $V_{OUT}$ is rendered $2^{-6}$ times smaller, so that zero-cross distortion at a small signal level is very small. Thus, with this D/A converter 100, D/A conversion can be achieved with less distortion even when the input data is small. In addition, this D/A converter 100 is advantageous in that the center of range of the output voltage $V_{OUT}$ can be set to any desired value by applying a proper bias voltage to the bias terminal 23.

Although the floating-point type D/A converter 100 has various advantages as described above, the input data to be applied thereto must be in the form of a floating-point number. And therefore, in the case where the data to be converted into an analog signal is ordinary binary data or data in a fixed-point form, the input data must be converted into data in a floating-point form. This is, however, troublesome.

A D/A converter 200 modified so that ordinary fixed-point binary data can be directly applied will now be described.

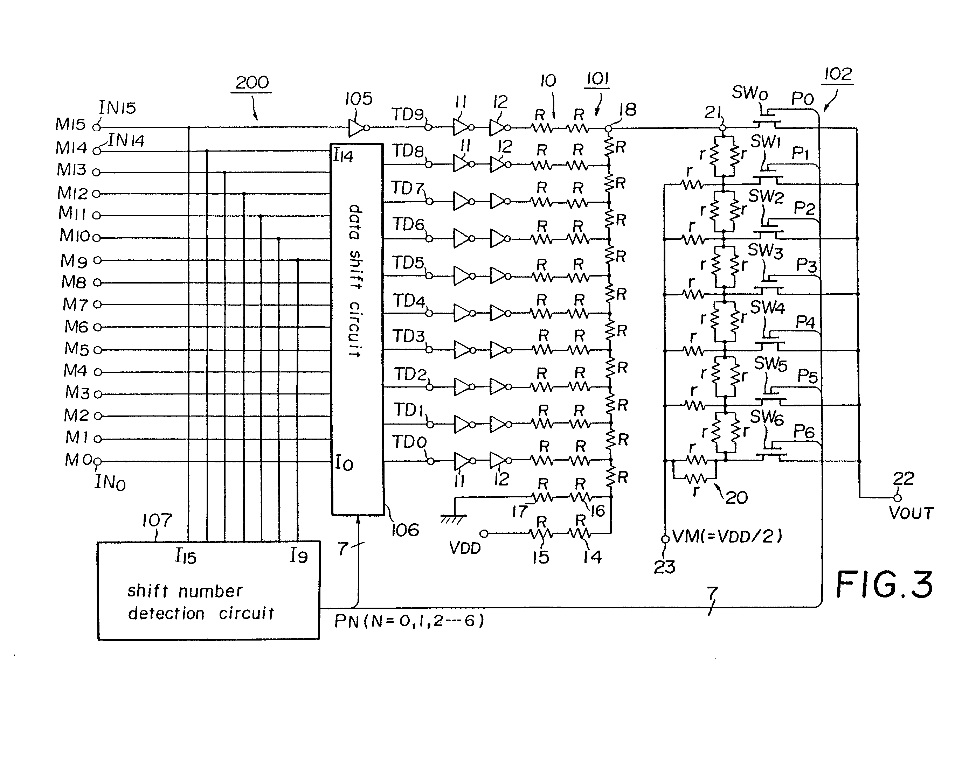

In Fig. 3, a digital input data of sixteen binary weighted bits $M_{15}$ to $M_0$ in two's complement form is supplied to input terminals $IN_{15}$ to $IN_0$ of the D/A converter 200. The MSB $M_{15}$ (sign bit) of the digital input data supplied to the input terminal $IN_{15}$ is inverted by an inverter 105 and fed to an input terminal $TD_9$ of a mantissa-part D/A conversion section 101 through serially connected two inverters 11 and 12. The remaining bits $M_{14}$ to $M_0$ supplied to the input terminals $IN_{14}$ to $IN_0$ are fed to input terminals $I_{14}$ to $I_0$ of a data shift circuit 106, respectively. Also, the bits $M_{15}$ to $M_9$ of the input data are supplied to input terminals $I_{15}$ to $I_9$ of a shift number detection circuit 107. This shift number detection circuit 107 selectively outputs one of seven signals $P_0$ to $P_6$ to the data shift circuit 106 and an exponent-part D/A conversion section 102 in accordance with the bits $M_{15}$ to $M_9$ of the input data.

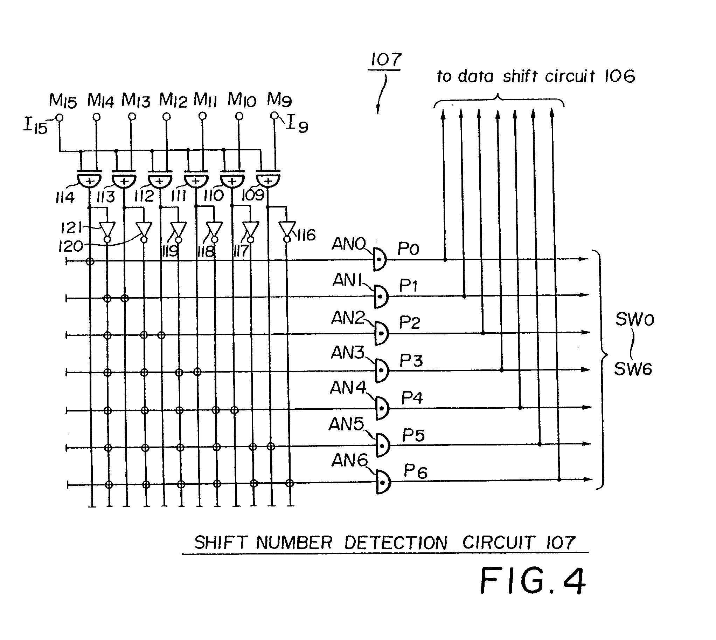

As shown in Fig. 4, the shift number detection circuit 107 comprises six exclusive-OR gates 109 to 114 to which the bits $M_9$ to $M_{14}$ are supplied, respectively, at one input terminals thereof. The other input terminals of the exclusive-OR gates 109 to 114 are supplied with the bit $M_{15}$ of the input data. This shift number detection circuit 107 further comprises seven AND gates $AN_0$ to $AN_6$. Input terminals of each of the AND gates $AN_0$ to $AN_6$ are indicated by circles on an input signal line of the corresponding one of the AND gates. Output terminals of the exclusive-OR gates 114 to 109 are connected to the first input terminals of the AND gates $AN_0$ to $AN_5$, respectively. The output terminals of the exclusive-OR gates 109 to 114 are also connected to input terminals of inverters 116 to 121, respectively. An output terminal of the inverter 116 is connected to the first input terminal of the AND gate $AN_6$, and an output terminal of the inverter 117 is connected to the second input terminals of the AND gates $AN_5$ and $AN_6$. An output terminal of the inverter 118 is connected to the second input terminal of the AND gate $AN_4$ and the third input terminals of the AND gates $AN_5$ and $AN_6$. In a similar manner, an output terminal of the inverter 119 is connected to the input terminals of the AND gates $AN_3$ to $AN_6$, an output terminal of the inverter 120 to the input terminals of AND gates $AN_2$ to $AN_6$, and an output terminal of the inverter 121 to the input terminals of the AND gates $AN_1$ to $AN_6$. When opened, the AND gates $AN_0$ to $AN_6$ output the signal $P_0$ to $P_6$, respectively. With this shift number detection circuit 107, when the bit $M_{15}$ is "0", that is to say, when the input data of this D/A converter 200 is a positive value, the "N" of the outputted signal $P_N$, is determined by the number of "0" bits of the input data counted from the bit $M_{14}$ toward the bit $M_9$ until a "1" bit is first detected. In other words, the "N" is determined by the number of leading "0" bits of the input data. For example, when the bit $M_{15}$ is "0" and if only the bits $M_{13}$ and $M_{11}$ are "1", the number of leading "0" bits of the input data is "1", so that the signal $P_1$ is outputted. On the other hand, when the bit $M_{15}$ is "1", that is to say, when the input data of this D/A converter 100 is negative, the "N" of the signal $P_N$ is determined by the number of "1" bits of the input data counted from the bit $M_{14}$ toward the bit $M_9$ until a "0" bit is first detected. In other words, the "N" is determined by the number of leading "1" bits of the input data. For example, in the case where only the bits $M_{10}$ and $M_9$ are "0", the number of leading "1" bits of the input data is "4", so that the signal $P_4$ is outputted. Thus, the shift number detection circuit 107 determines the "N" of the signal $P_N$ based on the number of those bits of the input data which are counted from the bit $M_{14}$ toward the bit $M_9$ until a bit different in state from the bit $M_{15}$ is first detected. In the case where a bit which is different in state from the bit $M_{15}$ is not detected from the bits $M_{14}$ to $M_9$, the shift number detection circuit 107 outputs the signal $P_6$ irrespective of the state of the bit $M_{15}$. Thus, the shift number detection circuit 107 selectively outputs the signal $P_N$ ("N" is one of "0" to "6") in accordance with the absolute value of the input data represented by the bits $M_{14}$ to $M_0$, wherein the "N" becomes greater when the absolute value of the input data becomes smaller.

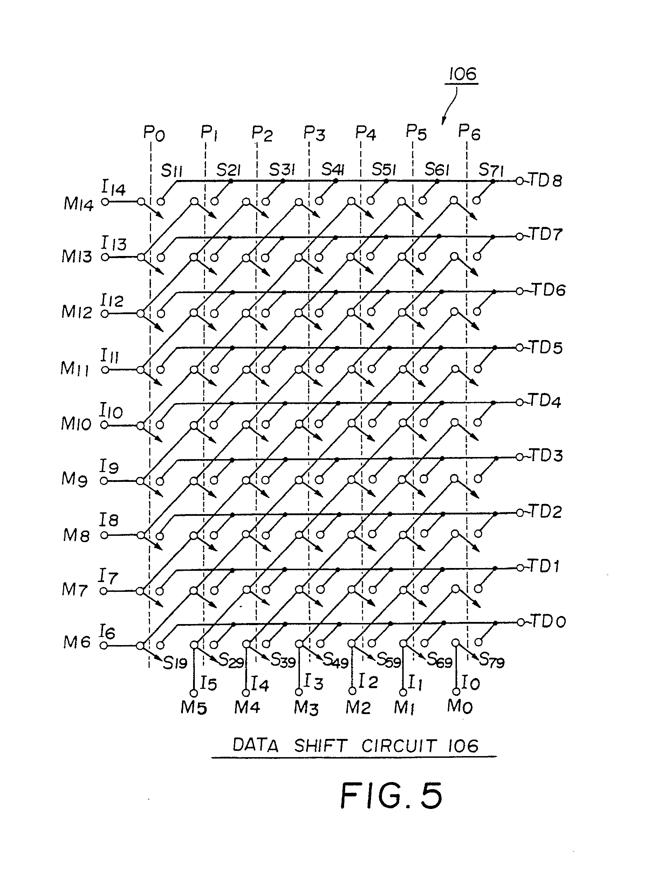

The data shift circuit 106 shown in Fig. 3 selects, based on the signal $P_N$ supplied from the shift number detection circuit 107, consecutive nine bits among the bits $M_{14}$ to $M_0$ and supplies the selected consecutive nine bits respectively to input terminals $TD_8$ to $TD_0$ of the mantissa-part D/A conversion section 101. This data shift circuit 106 comprises seven columns of switches $S_{11}$ to $S_{19}$, $S_{21}$ to $S_{29}$,...$S_{71}$ to $S_{79}$, as shown in Fig. 5. These switches may be constituted by FETs, transistors or the like. In this case, all of the switches of the same column are closed when the corresponding one of the signals $P_0$ to $P_6$ is applied thereto. For example, the switches $S_{11}$ to $S_{19}$ of the first column are closed when the signal $P_0$ is supplied thereto. In this case, the bits $M_{14}$ to $M_6$ of the input data are supplied respectively to the input terminals $TD_8$ to $TD_0$ of the mantissa-part D/A conversion section 101. In a similar manner, when the signal $P_1$ is supplied to the data shift circuit 106, the switches $S_{21}$ to $S_{29}$ are closed, so that the bits $M_{13}$ to $M_5$ of the input data are supplied respectively to the input terminals $TD_8$ to $TD_0$ of the mantissa-part D/A conversion section 101. And, when the signal $P_6$ is supplied to the data shift circuit 106, the switches $S_{71}$ to $S_{79}$ are closed, so that the bits $M_8$ to $M_0$ of the input data are supplied respectively to the input terminals $TD_8$ to $TD_0$ of the mantissa-part D/A conversion section 101.

In this embodiment, all of the above-described circuits are formed in a single chip of semiconductor.

The operation of this D/A converter 200 will now be described.

When a digital input data of sixteen bits $M_{15}$ to $M_0$ is supplied to the input terminals $IN_{15}$ to $IN_0$, the shift number detection circuit 107 determines, in accordance with the bits $M_{15}$ to $M_9$ of the input data, the number of bit "N" ("N" is one of "0" to "6") the data shift circuit 106 should shift the input data, and outputs the signal $P_N$. The data shift circuit 106 shifts in response to the signal $P_N$ the bits $M_{14}$ to $M_0$ of the input data in the direction of the higher significant bits by "N" bits, and outputs the result of the shift to the input terminals $TD_8$ to $TD_0$ of the mantissa-part D/A conversion section 101. The mantissa-part D/A conversion section 101 converts the magnitude of the data supplied to the input terminals $TD_8$ to $TD_0$ into an analog voltage having a polarity determined by the bit $M_{15}$ supplied to the input terminal $TD_9$ and outputs this voltage to the exponent-part D/A conversion section 102. The exponent-part D/A conversion section 102 then analogically shifts the voltage supplied from the mantissa-part D/A conversion section 101 by an amount determined by the signal $P_N$ and outputs the resultant voltage to the output terminal 22 as an output voltage $V_{OUT}$ which is expressed as follows:

$$V_{OUT} = 1/2\ V_{DD} + 1/4\ V_{DD}\ (-1 + \overline{M_{15}} + M_{14\text{-}N} \cdot 2^{-1} + M_{13\text{-}N} \cdot 2^{-2} + ... + M_{6\text{-}N} \cdot 2^{-9} + 2^{-10}) \cdot 2^{-N} \quad ...\text{-} (3)$$

In the above formula (3), the "N" is determined, as described above, based on the number of leading bits of the input data which are different in state from the bit $M_{15}$.

With this D/A converter 200, in the case where the absolute value of the input data represented by the bits $M_{14}$ to $M_0$ thereof is large, only higher significant bits of the input data are supplied to the mantissa-part D/A conversion section 101 and the remaining lower significant bits thereof are neglected. In this case, however, the value represented by the neglected bits is sufficiently smaller than that represented by all of the bits $M_{14}$ to $M_0$, and therefore, the neglect of the lower significant bits has little effect on the output voltage $V_{OUT}$ of this D/A converter 200. On the other hand, in the case where the absolute value of the input data is small, lower significant bits of the input data are supplied to the mantissa-part D/A conversion section 101, and therefore, this D/A converter 200 can converts a small signal accurately. For example, in the case where the "N" is "6", the bits $M_8$ to $M_0$ of the input data are supplied to the mantissa-part D/A conversion section 101, and in addition the error which may occur in the conversion of these bits is rendered $2^{-6}$ times smaller, as will be appreciated from the formula (3), and therefore the zero-cross distortion of the output signal $V_{OUT}$ is minimized.

As described above, with the structure of this D/A converter 200, an error in D/A conversion at a small signal level is minimized, and the input digital data to be converted into an analog form may be applied thereto in the form of an ordinary fixed point binary data, i. e., data composed only of binary weighted bits. Furthermore, this D/A converter 200 can easily be formed on a single chip of semiconductor to eliminate noise interference from the exterior circuits and to reduce its manufacturing cost. The D/A converter thus formed in a single chip of semiconductor is easy to use since digital data in the form of an ordinary binary data can be directly applied to the digital data input terminals thereof.

Though the described embodiments are examples in which a ten bit mantissa section and a six bit exponent section cooperatively convert sixteen bit digital data, the present invention is not limited thereto and each of the mantissa section and the exponent section may handle digital data of other bit structure to convert the sixteen bit digital data or to convert digital data other than sixteen bits.

## Claims

1. A digital-to-analog converter (100; 200) for converting digital data into an analog output signal ($V_{out}$) comprising

a) mantissa digital-to-analog converting means (101) for converting a mantissa part of said digital data into a first analog signal;

b) circuit means (102) responsive to said first analog signal to produce second analog signals whose voltages are $2^{-n}$ (n = 0,1, 2, 3, ...) magnifications of said first analog signal; and

c) switch circuit means connected to said circuit means for selectively outputting one of said second analog signals as said analog output signal in accordance with an exponent part of said digital data,

**characterized** in that said circuit means (102) comprises an r-2r ladder network directly connected at one terminal end thereof to said one terminal end of said mantissa digital-to-analog converting means (101) for producing said second analog signals, wherein said r-2r resistor ladder network is supplied at one terminal of each 2r resistor thereof with a bias voltage (23) to determine the center of range of said analog output signal ($V_{out}$).

2. A digital-to-analog converter according to claim 1, wherein said digital data is a fixed point binary data, characterized by data converting means for converting said fixed-point binary data into the floating point data composed of said mantissa part and exponent part.

3. A digital-to-analog converter according to claim 2, wherein said data converting means comprises:

detection means (107) for detecting as said exponent part the number of leading "0" bits of said binary data when said binary data is positive and for detecting as said exponent part the number of leading "1" bits of said binary data when said binary data is negative, said detection means outputting a signal ($P_N$) representative of said detected number; and

shifting means (106) responsive to said signal ($P_N$) outputted from said detecting means (107) for shifting said binary data in the direction of the most significant bit thereof by bits equal in number to said detected number to form said mantissa part;

said switch circuit means outputting one of said second analog signals as said analog output signal in response to said signal outputted from said detecting means.

4. A digital-to-analog converter according to anyone of the preceding claims, wherein said mantissa digital-to-analog converting means (101) comprises an R-2R resistor ladder network, each 2R resistor of said R-2R resistor ladder network being supplied with a corresponding bit of said mantissa part, and said first analog signal being derived from one terminal end of said R-2R ladder network.

## Revendications

1. Convertisseur numérique-vers-analogique (100; 200) pour convertir une donnée numérique en un signal de sortie analogique ($V_{out}$) comprenant :

a) un moyen de conversion numérique-vers-analogique de mantisse (101) pour convertir une partie mantisse de ladite donnée numérique en un premier signal analogique;

b) un moyen de circuit (102) sensible audit premier signal analogique pour produire des seconds signaux analogiques dont les tensions sont des amplifications par $2^{-n}$ (n = 0, 1, 2, 3, ...) dudit premier signal analogique; et

c) un moyen de circuit de commutation connecté audit moyen de circuit pour sortir de manière sélective l'un desdits seconds signaux analogiques en tant que ledit signal de sortie analogique en fonction d'une partie exposant de ladite donnée numérique,

caractérisé en ce que ledit moyen de circuit (102) comprend un réseau en échelle r-2r connecté directement par l'une de ses bornes d'extrémité à ladite une borne d'extrémité dudit moyen de conversion numérique-vers-analogique de mantisse (101) pour produire lesdits seconds signaux analogiques, dans lequel ledit réseau de résistances en échelle r-2r est alimenté sur l'une des bornes de chacune de ses résistances 2r avec une tension de polarisation (23) pour déterminer le centre de la plage dudit signal de sortie analogique ($V_{out}$).

2. Convertisseur numérique-vers-analogique selon la revendication 1, dans lequel ladite donnée numérique est une donnée binaire à virgule fixe, caractérisé par un moyen de conversion de donnée pour convertir ladite donnée binaire à virgule fixe en une donnée à virgule flottante composée de ladite partie de mantisse et de ladite partie d'exposant.

3. Convertisseur numérique-vers-analogique selon la revendication 2, dans lequel ledit moyen de conversion comprend :

un moyen de détection (107) pour détecter en tant que ladite partie d'exposant le nombre de bits à "0" en tête de ladite donnée binaire lorsque ladite donnée binaire est positive et pour détecter en tant que ladite partie d'exposant le nombre de bits à "1" en tête de ladite donnée binaire lorsque ladite donnée binaire est négative, ledit moyen de détection sortant un signal ($P_N$) représentatif dudit nombre détecté; et

un moyen de décalage (106) réagissant audit signal ($P_N$) sorti dudit moyen de détection (107) pour décaler ladite donnée binaire dans le sens du bit le plus significatif de celle-ci d'un nombre de bits égal audit nombre détecté pour former ladite partie de mantisse;

ledit moyen de circuit de commutation sortant l'un desdits seconds signaux analogiques en tant que ledit signal analogique de sortie en réponse audit signal sorti dudit moyen de détection.

4. Convertisseur numérique-vers-analogique selon l'une quelconque des revendications précédentes, dans lequel ledit moyen de conversion numérique-vers-analogique de mantisse (101) comprend un réseau de résistances en échelle R-2R, chaque résistance 2R dudit réseau de résistances en échelle R-2R étant alimentée avec un bit correspondant de ladite partie de mantisse, et ledit premier signal analogique étant obtenu à partir de l'une des bornes d'extrémité dudit réseau en échelle R-2R.

**Patentansprüche**

1. Digital/Analog-Wandler (100; 200) zum Umwandeln von Digitaldaten in ein Analogausgangssignal ($V_{out}$)

a) mit Digital/Analog-Mantissekonvertierungsmitteln (101) zum Umwandeln eines Mantissenteils der Digitaldaten in ein erstes Analogsignal;

b) mit Schaltungsmitteln (102), die auf das erste Analogsignal ansprechen, um zweite Analogsignale zu erzeugen, deren Spannungen $2^{-n}$ (n = 0,1,2,3, ...) Vergrößerungen des ersten Analogsignals sind,

c) und mit Umschaltmitteln, die an die Schaltungsmittel angeschlossen sind, um wahlweise eines der zweiten Analogsignale als das Analogausgangssignal entsprechend einem Exponententeil der Digitaldaten auszugeben,

dadurch **gekennzeichnet**, daß die Schaltungsmittel (102) ein r-2r-Leiternetzwerk aufweisen, das direkt mit einem Endanschluß an den Endanschluß der Digital/Analog-Mantissekonvertierungsmittel (101) angeschlossen ist, um die zweiten Analogsignale zu erzeugen, wobei das r-2r-Widerstands-Leiternetzwerk an einem Ende eines jeden seiner 2r-Widerstände mit einer Vorspannung (23) beaufschlagt ist, um die Bereichsmitte des Ausgangssignals ($V_{out}$) zu bestimmen.

2. Digital/Analog-Wandler nach Anspruch 1, bei dem die Digitaldaten Fixkomma-Binärdaten sind, gekennzeichnet durch Datenumwandlungsmittel zum Umwandeln der Fixkomma-Binärdaten in Gleitkommadaten, die sich aus dem Mantissenteil und dem Exponententeil zusammensetzen.

3. Digital/Analog-Wander nach Anspruch 2, bei dem Datenumwandlungsmittel folgendes aufweisen:

Nachweismittel (107) zum Feststellen der Zahl der führenden 0-Bits der Binärdaten als Exponententeil, wenn die Binärdaten positiv sind, und zum Feststellen der Zahl der führenden 1-Bits der Binärdaten, wenn die Binärdaten negativ sind, welche Nachweismittel ein Signal ($P_N$) ausgeben, das repräsentativ für die festgestellte Zahl ist,

und Schiebemittel (106), die auf das von den Nachweismitteln (107) gelieferte Signal ansprechen, um die Binärdaten in Richtung auf ihr höchstwertiges Bit um soviel Bits zu verschieben, wie der festgestellten Zahl entspricht, um den Mantissenteil zu bilden;

wobei die Umschaltmittel eines der zweiten Analogsignale als das Analogausgangssignal im Ansprechen auf das von den Nachweismitteln ausgegebene Signal ausgeben.

4. Digital/Analog-Wandler nach einem der vorhergehenden Ansprüche, bei dem die Digital-Analog-Mantissekonvertierungsmittel (101) ein R-2R Widerstands-Leiternetzwerk aufweisen, wobei jeder 2R-Widerstand des R-2R Widerstandsnetzwerkes mit einem entsprechenden Bit das Mantissenteils beaufschlagt wird und das erste Analogsignal von einem Endanschluß des R-2R-Leiternetzwerkes abgeleitet wird.

FIG.2

FIG.1

FIG. 3

SHIFT NUMBER DETECTION CIRCUIT 107

# FIG.4

EP 0 177 902 B1

DATA SHIFT CIRCUIT 106

FIG. 5